# EUROPÄISCHE PATENTSCHRIFT

(11) **EP 0 729 179 B1**
(45) Veröffentlichungstag und Bekanntmachung des Hinweises auf die Patenterteilung: **05.07.2000**
(21) Anmeldenummer: 96810070.1
(22) Anmeldetag: 02.02.1996
(51) Int. Cl.: H01L 23/051

(54) **Druckkontaktgehäuse für Halbleiterbauelemente**
Pressure contact housing for semiconductor component
Boîtier de contact par pression pour composant semi-conducteur

(30) Priorität: 17.02.1995 DE 19505387
(43) Veröffentlichungstag der Anmeldung: 28.08.1996
(73) Patentinhaber: ABB Industrie AG, 5400 Baden (CH)
(72) Erfinder: Bolgiani, Fabio, CH-6500 Bellinzona (CH)
(74) Vertreter: ABB Patent Attorneys

(56) Entgegenhaltungen:
- EP-A- 0 159 797
- CH-A- 582 425
- US-A- 4 092 703

## Beschreibung

### Technisches Gebiet

Die Erfindung bezieht sich auf das Gebiet der Leistungselektronik. Sie geht aus von einem Druckkontaktgehäuse für Halbleiterbauelemente nach dem Oberbegriff des ersten Anspruchs.

### Stand der Technik

Ein solches Druckkontaktgehäuse ist schon in der Europäischen Patentanmeldung EP-A1-0 588 026 beschrieben. Diese Anmeldung offenbart ein abschaltbares Hochleistungs-Halbleiterbauelement, insbesondere in Form eines GTO, mit einem scheibenförmigen Halbleitersubstrat, welches konzentrisch in einem ringförmigen Isoliergehäuse zwischen einem mit Druck beaufschlagbaren, scheibenförmigen Kathodenkontakt und einem ebenfalls mit Druck beaufschlagbaren, scheibenförmigen Anodenkontakt angeordnet ist und auf der Seite des Kathodenkontakts durch einen Gatekontakt, in der Form eines Steuerelektrodenkontaktringes, kontaktiert wird. Hierbei ist der Kathodenkontakt über einen ersten Deckel mit dem einen Ende des Isoliergehäuses und der Anodenkontakt über einen zweiten Deckel mit dem anderen Ende des Isoliergehäuses verbunden. Dadurch wird ein nach aussen hermetisch abgeschlossenes Bauelement gebildet, wobei der Gatekontakt über eine nach aussen geführte Gatezuführung mit einem Gatestrom beaufschlagbar ist. Ein Aufbau mit niedriger Koppelinduktivität wird dadurch erreicht, dass die Gatezuführung rotationssymmetrisch ausgebildet und zum Kathodenkontakt konzentrisch angeordnet ist, und die Gatezuführung vom Kathodenkontakt durch einen einzigen Isolator elektrisch getrennt ist.
Durch die Druckkontaktierung wird der Steuerelektrodenkontaktring in axialer Richtung ein wenig bewegt. Wird das Leistungshalbleiterbauelement z.B. in einem Versuchsaufbau verwendet, so muss das Halbleitersubstrat häufig ein- und ausgespannt werden. Durch die dadurch hervorgerufenen Bewegungen des Steuerelektrodenkontaktringes kann sich der elektrische Kontakt zur Gateelektrode verschlechtern bzw. durch Materialermüdung gänzlich unterbrochen werden.

### Darstellung der Erfindung

Aufgabe der vorliegenden Erfindung ist es demzufolge, ein Druckkontaktgehäuse anzugeben, bei welchem ein dauernder, sicherer elektrischer Kontakt zur Steuerelektrode gewährleistet ist.

Diese Aufgabe wird bei einem Druckkontaktgehäuse der eingangs genannten Art durch die Merkmale des ersten Anspruchs gelöst.

Kern der Erfindung ist es also, dass der Steuerelektrodenkontaktring spiralförmige Ausnehmungen aufweist. Dadurch werden die beim Einspannen des Halbleitersubstrates hervorgerufenen axialen Bewegungen mittels Durchbiegen der spiralförmigen Ausnehmungen und dadurch resultierende, kleine Umdrehungen der Ringinnenseite aufgenommen.

Bei einem bevorzugten Ausführungsbeispiel wird die Spirale durch eine Evolvente eines Kreise gebildet. Das heisst die Ränder der Ausnehmungen verlaufen entlang der Evolvente eines Kreises. Diese Evolvente kann, um eine einfachere Konstruktion zu erhalten, durch Kreisbögen angenähert werden.

Ausserdem wird ein Leistungshalbleiterbauelement angegeben, welches ein erfindungsgemässes Gehäuse umfasst.

Der Vorteil des erfindungsgemässen Aufbaus besteht darin, dass die axialen Belastungen des Steuerelektrodenkontaktrings beim Einspannen des Gehäuses von den spiralförmigen Ausnehmungen aufgenommen werden, ohne dass sich eine nennenswerte Belastung des Materials ergibt. Dadurch kann ein dauernder elektrischer Kontakt zur Steuerelektrode gewährleistet werden.

### Kurze Beschreibung der Zeichnungen

Nachfolgend wird die Erfindung anhand von Ausführungsbeispielen im Zusammenhang mit den Zeichnungen näher erläutert.

Es zeigen:
- Fig. 1: Einen erfindungsgemässen Steuerelektrodenkontaktring von oben;
- Fig. 2: Ein Gehäuse nach der Erfindung von der Seite und im Schnitt.

Die in den Zeichnungen verwendeten Bezugszeichen und deren Bedeutung sind in der Bezeichnungsliste zusammengefasst aufgelistet. Grundsätzlich sind in den Figuren gleiche Teile mit gleichen Bezugszeichen versehen.

### Wege zur Ausführung der Erfindung

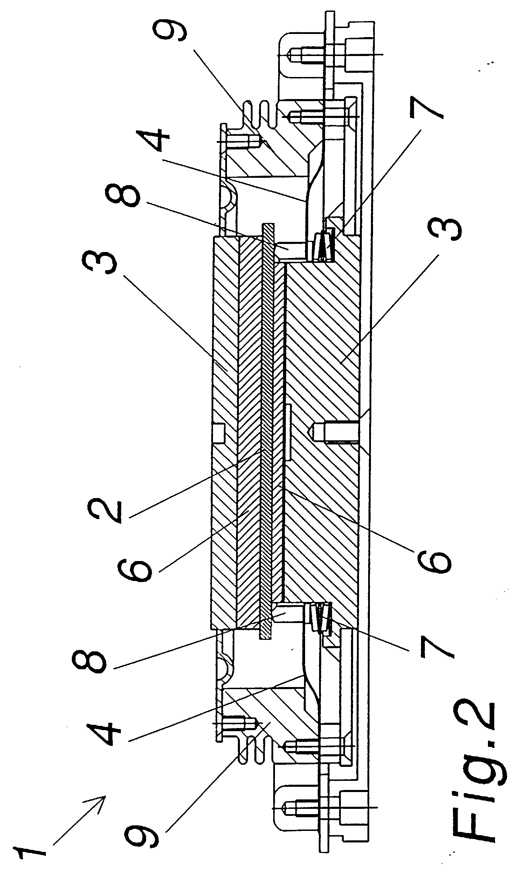

Figur 2 zeigt ein erfindungsgemässes Druckkontaktgehäuse 1 im Schnitt. Der Aufbau entspricht grundsätzlich demjenigen der EP-A1-0 588 026. Auf diese Schrift wird an dieser Stelle ausdrücklich verwiesen, und der Aufbau des Druckkontaktgehäuses wird hier nur insoweit beschreiben, als das es für die Erfindung notwendig ist.

Mit 2 ist ein Halbleitersubstrat bezeichnet. Dieses weist eine Anodenelektrode und eine Kathodenelektrode auf. Die Anode ist auf der Figur 2 der oberen Seite zugeordnet und wird von einem entsprechenden oberen Kontaktstempel 3 kontaktiert. Die Kathode befindet sich in Figur 2 auf der unteren Seite und wird von einem unteren Kontaktstempel 3 kontaktiert. Um den Wärmekontakt zu verbessern, ist zwischen den Kontaktstempeln 3 und dem Halbleitersubstrat 2 je eine Molybdänscheibe 6 vorgesehen. Die Steuerelektrode des Halbleitersubstrats 2 wird mittels auf Federn 7 gelagerten rotationssymmetrischen Steuerelektrodenzuführungen 8 und über einen nach aussen geführten Steuerelektrodenkontaktring 4 kontaktiert. Das Ganze ist in ein Isoliergehäuse 9 integriert.

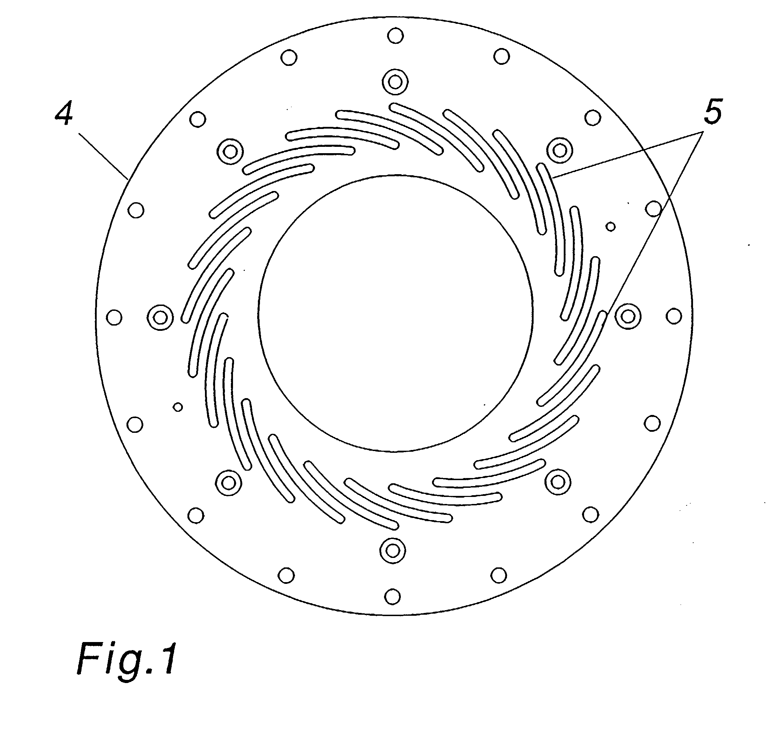

Für die Erfindung von Interesse ist vor allem der Steuerelektrodenkontaktring 4. Beim Einspannen des Halbleitersubstrats 2 in das Gehäuse 1, wobei die Kontaktstempel 6 mit Druck beaufschlagt werden, macht der Steuerelektrodenkontaktring 4 in axialer Richtung kleine Bewegungen mit. Ausserdem ist er, wie in Figur 2 deutlich zu sehen ist, in einem Teil gekrümmt. Um einen möglichst dauerhaften elektrischen Kontakt zu erhalten, ist der Steuerelektrodenkontaktring 4 nach der Erfindung wie in Figur 1 ausgeführt.

Im Bereich der Krümmung sind spiralförmige Ausnehmungen 5 vorgesehen. Diese haben den Vorteil, dass der Steuerelektrodenkontaktring 4 axiale Bewegungen bei der Montage problemlos aufnehmen kann. Die spiralförmigen Ausnehmungen 5 werden dabei durchgebogen und die Innenseite des Rings macht eine kleine Umdrehung mit. Die Ränder der Ausnehmungen 5 verlaufen vorzugsweise entlang einer Evolventen eines Kreises. Um die Herstellung zu vereinfachen, z.B. für numerisch gesteuerte Maschinen, kann die Evolvente aber auch durch Kreisbögen angenähert werden.

Im übrigen kann der Steuerelektrodenkontaktring mit Löchern zur Aufnahme von Befestigungsschrauben versehen sein.

Da die spiralförmigen Ausnehmungen 5 die bei der Montage des Gehäuses entstehenden Bewegungen aufnehmen kann, erfährt der Steuerelektrodenkontaktring nur geringe Belastungen des Materials. Dadurch kommt es zu keinen Materialermüdungserscheinungen, welche durch Bruch zu einer Verschlechterung oder gar einem Unterbruch des elektrischen Kontakt führen können.

### Bezeichnungsliste

- 1: Druckkontaktgehäuse
- 2: Halbleitersubstrat
- 3: Kontaktstempel
- 4: Steuerelektrodenkontaktring
- 5: Ausnehmung
- 6: Molybdänscheibe
- 7: Feder
- 8: Steuerelektrodenzuführung
- 9: Isoliergehäuse

## Patentansprüche

1. Druckkontaktgehäuse (1) für ein Halbleiterbauelement mit einem Halbleitersubstrat (2), welches eine erste und eine zweite Hauptelektrode und eine Steuerelektrode aufweist, wobei das Druckkontaktgehäuse (1) ein Isoliergehause (9), einen ersten und einen zweiten Kontaktstempel (3), und einen nach ausserhalb des Isoliergehäuses (9) führenden Steuerelektrodenkontaktring (4) aufweist und wobei nach Einbau des Halbleitersubstrats die erste und zweite Hauptelektrode zwischen dem ersten und dem zweiten Kontaktstempel (3) angeordnet und von diesen mit Druck beaufschlagt sind und wobei die Steuerelektrode mit dem nach ausserhalb des Gehäuses führenden Steuerelektrodenkontaktring (4) verbunden ist,
dadurch gekennzeichnet, dass der Steuerelektrodenkontaktring (4) spiralförmige Ausnehmungen (5) aufweist.

2. Gehäuse nach Anspruch 1, dadurch gekennzeichnet, dass die Ränder der Ausnehmungen (5) entlang einer Evolventen eines Kreises verlaufen.

3. Gehäuse nach Anspruch 2, dadurch gekennzeichnet, dass die Evolvente der Ausnehmungsränder einer Annäherung durch Kreisbögen entspricht.

4. Leistungshalbleiterbauelement, dadurch gekennzeichnet, dass es ein Druckkontaktgehäuse nach einem der Ansprüche 1 bis 3 und ein Halbleitersubstrat umfasst, welches eine erste und eine zweite Hauptelektrode und eine Steuerelektrode aufweist, und wobei die erste und zweite Hauptelektrode zwischen den jeweiligen Kontaktstempeln (3) angeordnet und von diesen mit Druck beaufschlagt sind und wobei die Steuerelektrode mit dem Steuerelektrodenkontaktring verbunden ist.

## Claims

1. Pressure contact housing (1) for a semiconductor component having a semiconductor substrate (2), which has a first and a second main electrode and a gate electrode, the pressure contact housing (1) having an insulating housing (9), a first and a second contact plunger (3), and a gate electrode contact ring (4) routed out of the insulating housing (9), and, after the fitting of the semiconductor substrate, the first and second main electrodes being arranged between the first and the second contact plunger (3) and pressure being applied to them by the said plungers, and the gate electrode being connected to the gate electrode contact ring (4) which is routed out of the housing, characterized in that the gate electrode contact ring (4) has spiral recesses (5).

2. Housing according to Claim 1, characterized in that the edges of the recesses (5) run along an involute of a circle.

3. Housing according to Claim 2, characterized in that the involute of the recess edges is approximated by circular arcs.

4. Power semiconductor component, characterized in that it comprises a pressure contact housing according to one of Claims 1 to 3, and a semiconductor substrate, which has a first and a second main electrode and a gate electrode, and the first and second main electrodes being arranged between the respective contact plungers (3) and pressure being applied to them by the said plungers, and the gate electrode being connected to the gate electrode contact ring.

## Revendications

1. Boîtier de contact par pression (1) pour un élément constitutif semi-conducteur avec un substrat semi-conducteur (2), lequel présente des première et deuxième électrodes principales et une électrode de commande, le boîtier de contact par pression (1) présentant un boîtier d'isolation (9), des premier et deuxième pistons de contact (3), et un anneau de contact des électrodes de commande (4) conduisant vers l'extérieur du boîtier d'isolation (9), les première et deuxième électrodes principales étant agencées après l'insertion du substrat semi-conducteur, entre les premier et deuxième pistons de contact (3) et étant admises par pression par ceux-ci et l'électrode de commande étant reliée à l'anneau de contact des électrodes de commande (4) conduisant vers l'extérieur du boîtier,
caractérisé en ce que l'anneau de contact des électrodes de commande (4) présente des creux (5) en forme de spirale.

2. Boîtier suivant la revendication 1, caractérisé en ce que les bords des creux (5) passent le long d'une développante d'un cercle.

3. Boîtier suivant la revendication 2, caractérisé en ce que la développante des bords des creux correspond à un rapprochement par des arcs de cercle.

4. Elément constitutif semi-conducteur de puissance, caractérisé en ce qu'il comprend un boîtier de contact par pression suivant l'une des revendications 1 à 3 et un substrat semi-conducteur, lequel présente une première et une deuxième électrodes principales et une électrode de commande, la première et la deuxième électrodes principales étant agencées entre les respectifs pistons de contact (3) les respectifs et étant admises par pression par ceux-ci et l'électrode de commande étant reliée à l'anneau de contact des électrodes de commande.
